# EUROPEAN PATENT APPLICATION

(11) **EP 0 572 779 A1**
(43) Date of publication of application: **08.12.1993**
(21) Application number: 93105580.0
(22) Date of filing: 05.04.1993
(51) Int. Cl.: H01L 33/00, H01L 27/15

(54) **Integrated display source with emissive polymers**

(30) Priority: 04.06.1992 US 894373
(71) Applicant: MOTOROLA, INC., Schaumburg, IL 60196 (US)
(72) Inventor: Nelson, Ronald J., Scottsdale, Arizona 85260 (US)
(74) Representative: Hudson, Peter David

(57) **Abstract**

A semiconductor driver (12) and a light emitting polymer element (14) connected to the driver and formed integrally therewith into a light emitting element. One or more of the elements being included in a display pixel and a plurality of pixels (84) being arranged into rows and columns for a display source. The light emitting elements are also used as interconnects for semiconductor ICs.

## Description

The present invention pertains to display sources for virtual image displays and more specifically to display sources integrated into control electronics.

### Background of the Invention

Certain electronic devices, including portable communications receivers, such as radios, cellular and cordless telephones, pagers and the like, portable computers, personal communicators, etc. are becoming increasingly popular. In many instances it is desirable to provide a visual display on the device to supply the operator with a visual message. The problem is that visual displays require relatively high electrical power and require a great amount of area to be sufficiently large to produce a useful display.

In the prior art, for example, it is common to provide visual displays utilizing liquid crystal displays, directly viewed light emitting diodes, etc. These produce very large and cumbersome displays that greatly increase the size of the device and require relatively large amounts of power. This makes it very difficult to incorporate the display into many portable devices.

In one instance, the prior art utilizes a scanning mirror to produce an enlarged visual display from a LED image source. However, LED image sources are very complicated to construct and, in this structure the image is fixed with no controls for changing the image.

### Summary of the Invention

It is a purpose of the present invention to provide a new and improved integrated display source.

It is a further object of the present invention to provide a new and improved integrated display source which is easy and inexpensive to integrate into semiconductor chips and the like.

The above problems are solved and additional advantages realized in a display source pixel comprising a semiconductor driver and a light emitting polymer element connected to the driver and formed integrally therewith.

The above problems are solved and additional advantages realized in a display source including a substrate having a surface, a plurality of pixels formed on the substrate and arranged in rows and columns with each pixel having an external row and column address input, each pixel of the plurality of pixels including a semiconductor driver formed in the substrate and having an output terminal, and a light emitting polymer element formed on the surface of the substrate and having an input terminal connected to the output terminal of the driver.

### Brief Description of the Drawings

Referring to the drawings:
FIG.1 is a simplified sectional view of a single pixel embodying the present invention;
FIG.2 is a simplified sectional view of another single pixel embodying the present invention;
FIG. 3 is a view in top plan of a display source incorporating a plurality of pixels similar to FIG. 1 and FIG. 2;
FIG. 4 is a view in perspective of an electronic device incorporating the display source of FIG. 3; and
FIG. 5 is a sectional view as seen from the line 5 - 5 of FIG. 4.

### Description of the Preferred Embodiment

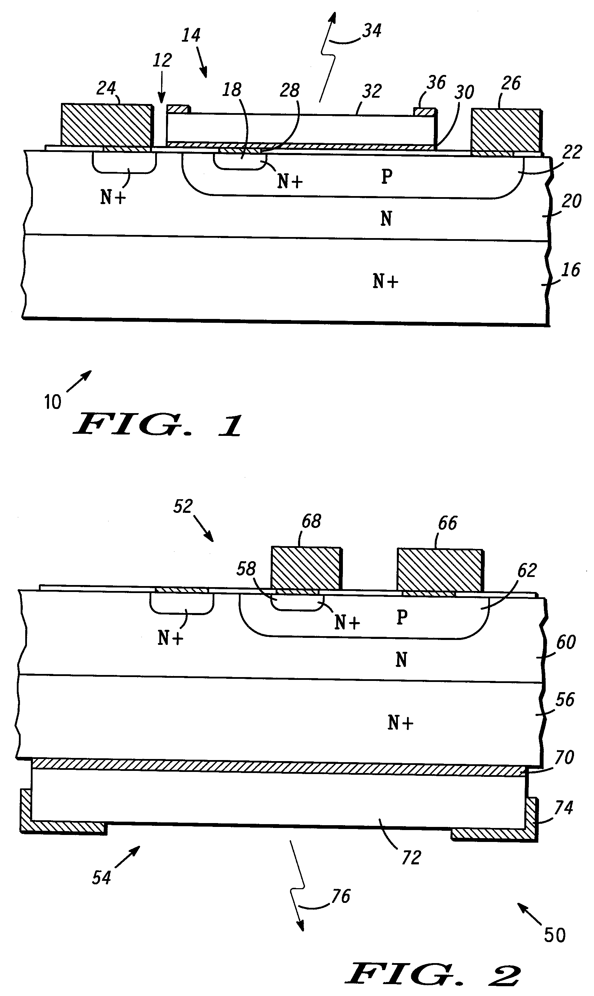

Referring specifically to FIG. 1, a simplified sectional view of a single pixel 10 for a display source is illustrated. Pixel 10 includes a semiconductor driver 12 and a light emitting polymer element 14. In this specific embodiment driver 12 is illustrated as a single transistor for simplicity of description and illustration. The single transistor of driver 12 is formed in a substrate 16 by any of the well known methods and includes an emitter 18, a collector 20 and a base 22. A metal pad 24 is electrically connected to collector 20 and forms an external connection for collector 20. A metal pad 26 is electrically connected to base 22 and forms an external connection for base 22.

Emitter 18 has a metalization layer 28 formed thereon by any of the well known methods. Light emitting polymer element 14 includes a layer 30 of rectifying metal, such as indium or calcium deposited in overlying relationship to metalization layer 28 and a layer 32 of semiconducting polymer deposited in overlying relationship to metal layer 30. Rectifying metal layer 30 and semiconductive polymer layer 32 form a diode which, when properly energized, emits light in the direction of arrow 34. A layer of metal 36, which overlies semiconductive polymer layer 32 around the edges thereof, forms an ohmic contact for supplying an activating potential to pixel 10. Metal layer 36 may be for example indium/tin-oxide and may cover the entire upper surface of semiconductive polymer 32 to improve the current flow and provide more light emission, if desired.

In this specific embodiment semiconductive polymer layer 32 includes poly 2-methoxy, 5-(2'-ethyl-hexoxy)-1, 4-phenylene-viylene, which is a p-type material that, when combined with Indium to produce a diode, conducts electrons from rectifying metal layer 30 through semiconductive polymer layer 32. Other semiconductive polymer material may be utilized to provide current flow of a different type carrier or in a different direction, if desired. Also, material other than indium may be utilized for the rectifying junction. Further, other semiconductive polymer material may be utilized to emit light of different colors, if desired.

Referring specifically to FIG. 2, a simplified sectional view of another single pixel 50 for a display source is illustrated. Pixel 50 includes a semiconductor driver 52 and a light emitting polymer element 54. In this specific embodiment driver 52 is illustrated as a single transistor for simplicity of description and illustration. The single transistor of driver 52 is formed in a substrate 56 by any of the well known methods and includes an emitter 58, a collector 60 and a base 62. A metal pad 66 is electrically connected to base 62 and forms an external connection for base 62. A metal pad 68 is electrically connected to emitter 58 and forms an external connection for emitter 58.

Collector 60, which in this embodiment is the reverse side of substrate 56, has a metalization layer 70 formed thereon by any of the well known methods. A layer 72 of semiconductive polymer is deposited in overlying relationship to metal layer 70 and forms an ohmic contact therebetween. Light emitting polymer element 54 also includes a layer 74 of rectifying metal, such as indium or calcium, deposited in overlying relationship to semiconductive polymer layer 72 to form a diode which, when properly energized, emits light in the direction of arrow 76. Rectifying metal layer 74, which overlies semiconductive polymer layer 72 around the edges thereof, also forms a contact for supplying an activating potential to pixel 50.

The embodiment illustrated in FIG. 1 has the advantage that rectifying metal layer 30 is positioned adjacent substrate 20 so that it does not reduce light flow from light emitting polymer element 14. Also, by completely covering the emitting surface with indium/tin-oxide, which is transparent to light, a more uniform current distribution is achieved. The embodiment illustrated in FIG. 2, on the other hand is easier to construct because light emitting polymer element 54 is not obstructed by metal pads 66 and 68. Therefore, the emitting surface of light emitting polymer element 54 is somewhat larger to offset the area covered by rectifying metal layer 74. It will of course be understood by those skilled in the art that other drivers incorporating other types of semiconductor devices may be utilized to realize many of these advantages in a single element.

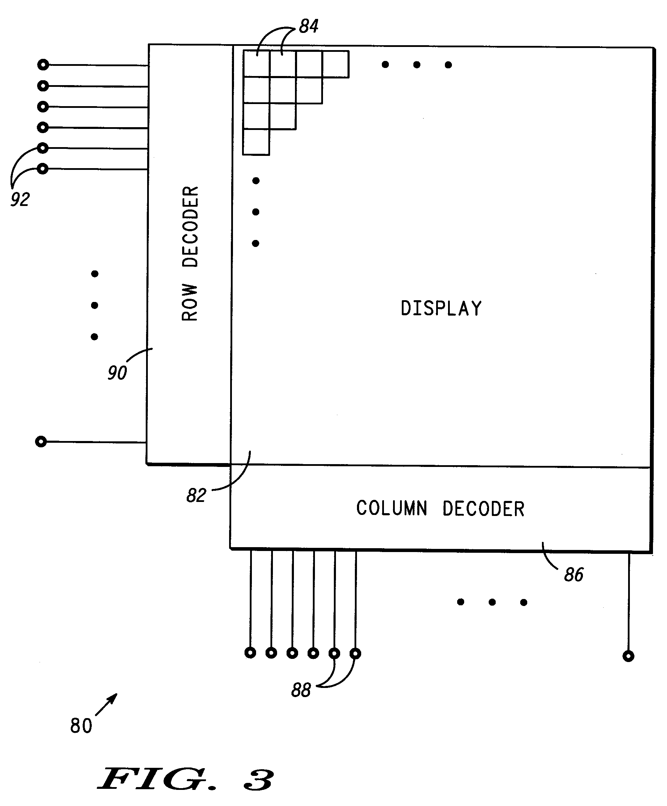

Referring specifically to FIG. 3, a display source 80 is illustrated in top plan. Display source 80 includes a display 82, which is a plurality of pixels 84 arranged in rows and columns. Display source 80 further includes a column decoder 86 electrically connected to pixels 84 and having a plurality of signal input terminals 88 and a row decoder 90 electrically connected to pixels 84 and having a plurality of signal input terminals 92. Each pixel 84 includes one or more light emitting polymer elements 10 or 50 with the driver portions connected to be operated by column and row decoders 88 and 90. Each pixel includes at least one light emitting polymer element, with additional parallel elements being included, if desired, for additional brightness and/or redundancy. By addressing specific pixels 84 by row and column in a well known manner, the specific pixels 84 are energized to produce a real image. Digital or analog data is received at an input terminal and converted by data processing circuits, not shown, into signals capable of energizing selected pixels 84 to generate the predetermined real image. Thus, image data is supplied to input terminals 88 and 92 and display 82 produces a desired image, which image may be continuous or changing in accordance with the image data.

Display source 80 is illustrated simply as a display and decoders but it will be understood that additional image generation apparatus, including data processing circuits may be included on the same or additional chips. Data processing circuits generally include logic and switching circuit arrays, some of which are incorporated into decoders 86 and 90, for controlling each pixel 84. Data processing circuits include, in addition to or instead of the logic and switching arrays, a microprocessor or similar circuitry for processing input signals to produce a desired real image on display 82. It will be understood by those skilled in the art that display 82 and decoders 86 and 90 are greatly enlarged in FIG. 3. The actual size of a semiconductor chip containing the entire image generation apparatus is on the order of a few milli-meters along each side with each pixel 84 being on the order of as little as ten microns on a side.

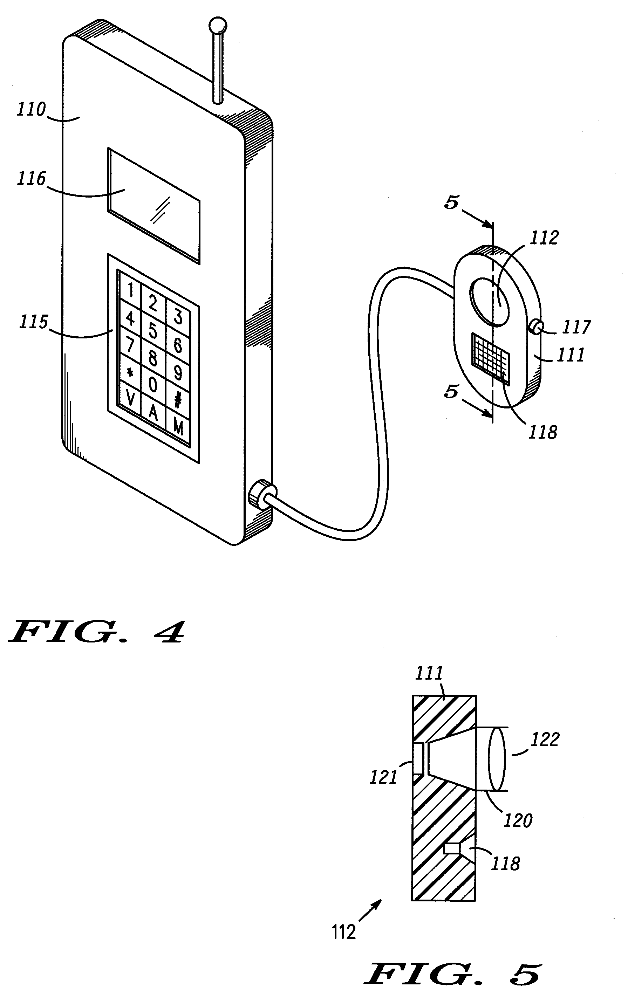

FIG. 4, illustrates a portable electronic device, which in this embodiment is a portable communications receiver 110 having a hand held microphone 111 with a miniature virtual display 112 mounted therein It will of course be understood that portable communications receiver 110 can be any of the well known portable receivers, such as a cellular or cordless telephone, a two-way radio, a pager, etc. In the present embodiment, for purposes of explanation only, portable communications receiver 110 is a portable two-way police radio, generally the type carried by police officers on duty or security guards. Portable communications receiver 110 includes a control panel 115 for initiating calls and a standard visual display 116, if desired, for indicating the number called or the number calling. Alternately, 116 includes a speaker in addition to or instead of the visual display. Hand held microphone 111 has a push-to-talk switch 117 and a voice pick-up 118.

Referring to FIG. 5, a simplified sectional view of hand held microphone 111 , as seen from the line 5 - 5, is illustrated. Miniature virtual display 112 includes image generation apparatus 121 for providing an image source to a fixed optical system 120, which in turn produces a virtual image viewable by the operator through an aperture 122. In this embodiment, image generation apparatus includes display source 80 along with timing, logic and switching arrays on a single semiconductor chip. Fixed optical system 120 is constructed to magnify the entire image source from image generation apparatus 121, without utilizing moving parts, so that the virtual image viewable through aperture 122 is a complete frame, or picture, which appears to be very large and is easily discernable by the operator.

By producing a virtual image from the very small image source of image generation apparatus 121, fixed optical system 120 is relatively small and adds virtually no additional space requirements to hand held microphone 111. Optical system 120 is constructed with no moving parts, other than optional features such as focusing, zoom lenses, etc. Further, image generation apparatus 121 requires very little electrical power to generate the real image and, therefore, adds very little to the power requirements of portable communications receiver 110.

Additional information on the use of virtual image displays in electronic devices is available in copending application entitled "Receiver with Miniature Virtual Image Display", filed September 30, 1991, serial number 07/767,178, and assigned to the same assignee.

Thus,improved light emitting polymer elements are disclosed which incorporate semiconductor drivers into the same element, The light emitting polymer elements can be used individually in semiconductor integrated circuits for conveying signals between different portions of the circuits or for conveying signals into and out of semiconductor chips. Further, improved display sources utilizing the light emitting polymer elements are disclosed which are simpler to construct and which can be included on a single semiconductor chip for ease in incorporating into various portable electronic devices. Further, the display source is controllable to provide any desired image, including continuous or changing images. It is anticipated that different semiconductor polymers can be incorporated into light emitting semiconductor elements so that different colors are emitted. By incorporating different colored light emitting semiconductor elements into each pixel, colored images are produced.

## Claims

1. An integrated display source characterized by a light emitting element including a semiconductor driver (12) and a light emitting polymer element (14) connected to the driver and formed integrally therewith.

2. An integrated display source as claimed in claim 1 further characterized by a substrate (16) having a surface with the semiconductor driver (12) being formed in the substrate and having a connecting terminal (28), the light emitting polymer element being formed on the surface of the substrate and having a connecting terminal (30) connected to the connecting terminal of the driver.

3. An integrated display source as claimed in claim 2 further characterized in that the connecting terminal of the driver and the connecting terminal of the polymer element are formed as the same structure.

4. An integrated display source as claimed in claim 2 further characterized in that the polymer element includes poly 2-methoxy, 5-(2'-ethyl-hexoxy)-1, 4-phenylene-viylene.

5. An integrated display source as claimed in claim 2 further characterized by a plurality of light emitting polymer elements (84).

6. An integrated display source as claimed in claim 5 further characterized in that each light emitting polymer element is constructed to emit a different color light.

7. An integrated display source as claimed in claim 2 further characterized in that a plurality of pixels (84) are formed on the substrate and arranged in rows and columns with each pixel having an external row and column address input (92, 88), each pixel of the plurality of pixels including a semiconductor driver (12) formed in the substrate (16) and having a connecting terminal, and a light emitting polymer element (14) formed on the surface of the substrate and having a connecting terminal connected to the connecting terminal of the driver.

8. An integrated display source as claimed in claim 7 and further characterized by a portable electronic device (110) with a miniature virtual image display (112) having a viewing aperture (122), the display being operably attached to the electronic device and including image generation apparatus (121) for providing an image source and a fixed optical system (120) for producing, from the image source, a virtual image viewable through the viewing aperture, the plurality of pixels forming the image generation apparatus.
